(19) Europäisches Patentamt
European Patent Office
Office européen des brevets

(11) EP 4 379 408 A1

(12) # EUROPÄISCHE PATENTANMELDUNG

(43) Veröffentlichungstag:
**05.06.2024 Patentblatt 2024/23**

(21) Anmeldenummer: **22211010.8**

(22) Anmeldetag: **02.12.2022**

(51) Internationale Patentklassifikation (IPC):
***G01R 31/62*** *(2020.01)*

(52) Gemeinsame Patentklassifikation (CPC):
**G01R 31/62**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**KH MA MD TN**

(71) Anmelder: **Siemens Aktiengesellschaft**
**80333 München (DE)**

(72) Erfinder:
- **Menke, Peter**
  **96047 Bamberg (DE)**
- **Mieske, Frank**
  **13053 Berlin (DE)**

(74) Vertreter: **Siemens Patent Attorneys**
**Postfach 22 16 34**
**80506 München (DE)**

(54) ## VERFAHREN UND EINRICHTUNG ZUM ERKENNEN EINES FEHLERS EINES MEHRPHASIGEN ANALOGEN MESSWANDLERS

(57) Die Erfindung bezieht sich unter anderem auf ein Verfahren zum Erkennen eines Fehlers eines mehrphasigen analogen Messwandlers (20). Erfindungsgemäß ist vorgesehen, dass für jede Phase (L1, L2, L3) des Messwandlers (20) jeweils ein Sekundärmesswert (M1, M2, M3) gebildet wird, der ein auf einer Sekundärseite (21) des Messwandlers (20) vorliegendes Sekundärsignal beschreibt, für eine zu überprüfende Phase (L1, L2, L3) des Messwandlers (20) ein Mindestschwellenwert ermittelt wird, der ein Überkoppelsignal angibt, das im fehlerfreien Falle durch ein Übersprechen einer oder mehrerer anderer Phasen (L1, L2, L3) des Messwandlers (20) auf der Sekundärseite (21) der zu überprüfenden Phase (L1, L2, L3) mindestens vorliegen müsste, der Sekundärmesswert (M1, M2, M3) der zu überprüfenden Phase (L1, L2, L3) mit dem Mindestschwellenwert verglichen wird und in Abhängigkeit von dem Vergleichsergebnis auf Ausfallfreiheit oder das Auftreten eines Fehlers bezüglich der zu überprüfenden Phase (L1, L2, L3) des Messwandlers (20) geschlossen wird.

FIG 2

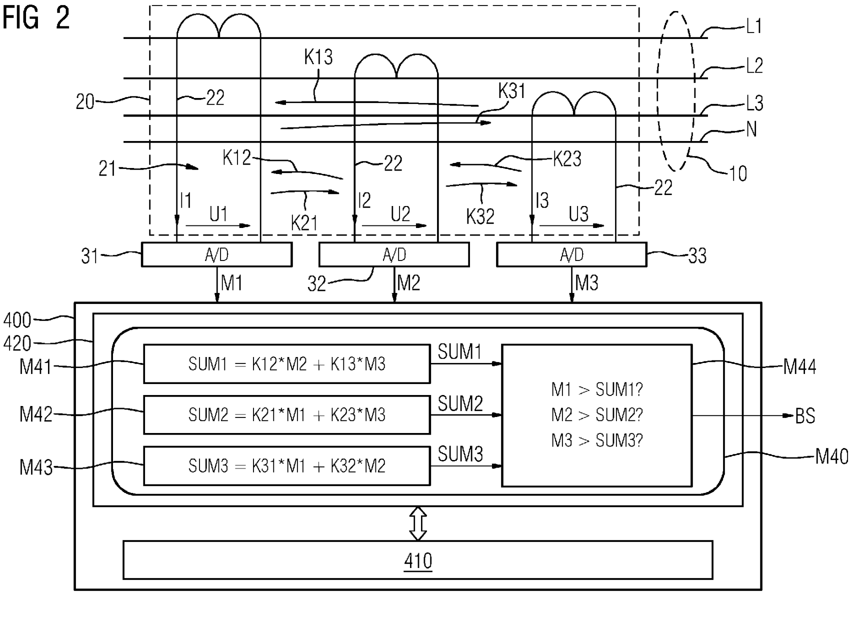


EP 4 379 408 A1

**Beschreibung**

Die Erfindung bezieht sich auf Verfahren und Einrichtungen zum Erkennen eines Fehlers eines mehrphasigen analogen Messwandlers.

Insbesondere im Bereich der Energieübertragungstechnik besteht das Problem, dass eine Kabelunterbrechung beispielsweise durch einen Kabelbruch in einer Phase eines mehrphasigen Messwandlers nachgeordneten Geräten wie beispielsweise Schutzgeräten oder Merging Units Differenzströme vortäuschen können. Solche Differenzströme können von Schutzfunktionen dieser Geräte oder nachgeordneter Geräte als Fehler in der an den Messwandler angeschlossenen Energieversorgungsleitung interpretiert werden, obwohl ein solcher Fehler dort tatsächlich gar nicht vorliegt. Unter ungünstigen Umständen können die fehlerhaft festgestellten Differenzströme zu einer unerwünschten Überfunktion führen und eine Abschaltung der Energieversorgungsleitung oder Abschnitten der Energieversorgungsleitung hervorrufen, wodurch auch die Stabilität der gesamten Energieversorgung unnötig gefährdet werden könnte.

Der Erfindung liegt die Aufgabe zugrunde, ein Verfahren zum Erkennen eines Fehlers eines mehrphasigen analogen Messwandlers anzugeben, das sich einfach und ohne großen Aufwand durchführen lässt.

Diese Aufgabe wird erfindungsgemäß durch ein Verfahren mit den Merkmalen gemäß Patentanspruch 1 gelöst Vorteilhafte Ausgestaltungen des erfindungsgemäßen Verfahrens sind in Unteransprüchen angegeben.

Danach ist erfindungsgemäß vorgesehen, dass für jede Phase des Messwandlers jeweils ein Sekundärmesswert gebildet wird, der ein auf einer Sekundärseite des Messwandlers vorliegendes Sekundärsignal beschreibt, für eine zu überprüfende Phase des Messwandlers ein Mindestschwellenwert ermittelt wird, der ein Überkoppelsignal angibt, das im fehlerfreien Falle durch ein Übersprechen einer oder mehrerer anderer Phasen des Messwandlers auf der Sekundärseite der zu überprüfenden Phase mindestens vorliegen müsste, der Sekundärmesswert der zu überprüfenden Phase mit dem Mindestschwellenwert verglichen wird und in Abhängigkeit von dem Vergleichsergebnis auf Ausfallfreiheit oder das Auftreten eines Fehlers bezüglich der zu überprüfenden Phase des Messwandlers geschlossen wird.

Ein wesentlicher Vorteil des erfindungsgemäßen Verfahrens besteht darin, dass sich dieses mit minimalem Geräteaufwand durchführen lässt. Der erfindungsgemäße Gedanke besteht darin, dass bei mehrphasigen Messwandlern aufbaubedingt bzw. physikalisch bedingt stets ein gewisses Übersprechen bzw. Überkoppeln der Sekundärsignale untereinander zwischen den Phasen auftritt. Aufgrund der auftretenden Überkopplung muss in jeder Phase des Messwandlers also ein Sekundärsignal größer als Null feststellbar sein, wenn zumindest in einer der Phasen ein Sekundärsignal größer als Null festgestellt wird. An dieser Stelle setzt das erfindungsgemäße Verfahren an, indem es die Höhe der Sekundärsignale in den einzelnen Phasen untereinander einer Vergleichsoperation unterzieht, in der geprüft wird, ob die Sekundärmesswerte mit Blick auf das unvermeidliche Überkoppeln (Übersprechen) untereinander plausibel sind. Eine solche Plausibilitätsprüfung lässt sich in einfacher Weise durch einen einfachen Vergleich durchführen.

Auf Ausfallfreiheit in der zu überprüfenden Phase des Messwandlers wird vorzugsweise geschlossen, wenn der Sekundärmesswert den Mindestschwellenwert überschreitet.

Auf einen Fehler in der zu überprüfenden Phase des Messwandlers wird vorzugsweise geschlossen, wenn der Sekundärmesswert den Mindestschwellenwert unterschreitet.

Insbesondere dann, wenn es sich bei den auf der Sekundärseite vorliegenden Sekundärsignalen um - von Oberwellen oder Störungen abgesehen - sinusförmige Wechselsignale mit einer vorgegebenen Grundfrequenz handelt, wird es als vorteilhaft angesehen, wenn die Sekundärmesswerte Amplituden- oder Effektivwerte sind. Vorzugsweise sind die Sekundärmesswerte also Werte, die die Signalamplitude oder den Effektivwert des jeweiligen Sekundärsignals - bezogen auf die vorgegebene Frequenz wie beispielsweise die Grundfrequenz einer Energieversorgungsleitung - angeben.

Vorteilhaft ist es, wenn für jede der anderen Phasen als der zu überprüfenden Phase jeweils ein phasenpaarbezogener Teilkoppelsignalwert errechnet wird, und zwar durch Multiplikation eines phasenpaarbezogenen, das Überkoppeln zwischen der jeweiligen anderen Phase und der zu überprüfenden Phase quantifizierenden Koppelwerts und dem Sekundärmesswert der jeweiligen anderen Phase, die phasenpaarbezogenen Teilkoppelsignalwerte der anderen Phasen unter Bildung eines Summenwerts aufsummiert werden und der Summenwert als der Mindestschwellenwert angesehen und für den Vergleich mit dem Sekundärmesswert der zu überprüfenden Phase herangezogen wird.

Alternativ oder zusätzlich kann vorgesehen sein, dass für eine andere als die zu überprüfende Phase ein phasenpaarbezogener Teilkoppelsignalwert errechnet wird, und zwar durch Multiplikation eines phasenpaarbezogenen, das Überkoppeln zwischen der anderen Phase und der zu überprüfenden Phase quantifizierenden Koppelwerts und dem Sekundärmesswert der anderen Phase, und der phasenpaarbezogene Teilkoppelsignalwert als der Mindestschwellenwert angesehen und für den Vergleich mit dem Sekundärmesswert der zu überprüfenden Phase herangezogen wird.

Bei der letztgenannten Ausgestaltung ist es vorteilhaft, wenn als die andere als die zu überprüfende Phase diejenige andere Phase ausgewählt wird, deren Sekundärmesswert der größte Sekundärmesswert im Vergleich zu den Sekundärmesswerten aller übrigen der anderen Phasen ist, und als die zu überprüfende Phase diejenige Phase ausgewählt wird, deren Sekundärmesswert der kleinste ist.

Auf einen Fehler in der zu überprüfenden Phase des Messwandlers wird vorzugsweise geschlossen, wenn der Sekundärmesswert den phasenpaarbezogenen Teilkoppelsignalwert unterschreitet.

Auch ist es von Vorteil, wenn jede der Phasen des Messwandlers jeweils auf das Vorliegen eines Fehlers geprüft wird, indem das Verfahren für jede der Phasen als zu überprüfende Phase durchgeführt wird.

Im Falle, dass auf das Auftreten eines Fehlers des Messwandlers geschlossen wird, wird vorzugsweise ein Blockadesignal erzeugt, mit dem zumindest eine Schutzfunktion eines Schutzgeräts blockiert wird.

Die Sekundärsignale, die ausgewertet werden, können Sekundärströme und die Sekundärmesswerte, die ausgewertet werden, können Sekundärstromwerte sein, die die auf der Sekundärseite fließenden Sekundärströme angeben; die Überkoppelsignale, auf die abgestellt wird, wären in diesem Falle Überkoppelströme.

Alternativ können die Sekundärsignale, die ausgewertet werden, Sekundärspannungen und die Sekundärmesswerte, die ausgewertet werden, Sekundärspannungswerte sein, die die auf der Sekundärseite anliegenden Sekundärspannungen angeben; die Überkoppelsignale, auf die abgestellt wird, wären in diesem Falle Überkoppelspannungen.

Die Erfindung bezieht sich darüber hinaus auf eine Fehlerdetektionseinrichtung zum Erkennen eines Fehlers in einer Phase eines mehrphasigen analogen Messwandlers. Erfindungsgemäß ist bezüglich einer solcher Fehlerdetektionseinrichtung vorgesehen, dass die Fehlerdetektionseinrichtung eine Vergleichseinrichtung aufweist, die für eine zu überprüfende Phase des Messwandlers einen Mindestschwellenwert ermittelt, der ein Überkoppelsignal beschreibt, das im fehlerfreien Falle durch ein Übersprechen einer oder mehrerer anderer Phasen des Messwandlers auf der Sekundärseite der zu prüfenden Phase mindestens vorliegen müsste, einen das auf der Sekundärseite der zu prüfenden Phase tatsächlich vorliegende Sekundärsignal angebenden Sekundärmesswert mit dem Mindestschwellenwert vergleicht und in Abhängigkeit von dem Vergleichsergebnis auf Ausfallfreiheit oder das Auftreten eines Fehlers in der zu überprüfenden Phase des Messwandlers schließt.

Bezüglich der Vorteile der erfindungsgemäßen Fehlerdetektionseinrichtung und deren vorteilhafter Ausgestaltungen sei auf die obigen Ausführungen im Zusammenhang mit dem erfindungsgemäßen Verfahren und dessen vorteilhafter Ausgestaltungen verwiesen.

Vorteilhaft ist es, wenn die Fehlerdetektionseinrichtung dazu ausgestaltet ist, den Messwandler für jede der Phasen individuell auf das Vorliegen eines Fehlers hin zu prüfen.

Die Fehlerdetektionseinrichtung ist vorzugsweise als Funktionsmodul in ein Schutzgerät oder eine Merging Unit integriert.

Alternativ oder zusätzlich kann in vorteilhafter Weise vorgesehen sein, dass die Fehlerdetektionseinrichtung durch ein Softwaremodul gebildet ist, das auf einer Rechenanlage installiert ist.

Beispielsweise ist es vorteilhaft, wenn die Fehlerdetektionseinrichtung durch ein Softwaremodul gebildet ist, das einen Bestandteil der Betriebssoftware eines Schutzgeräts oder einer Merging Unit bildet.

Die Erfindung bezieht sich außerdem auf ein Schutzgerät und eine Merging Unit. Erfindungsgemäß sind das Schutzgerät und die Merging Unit mit einer Fehlerdetektionseinrichtung wie oben beschrieben ausgestattet.

Vorteilhaft ist es, wenn die Merging Unit die Gültigkeit der von ihr an andere Geräte übertragenen Messwerte mit Statusbits entsprechend kennzeichnet.

Die Erfindung bezieht sich außerdem auf eine Anordnung mit einer mehrphasigen Energieversorgungsleitung, einem Messwandler, der mit einer Primärseite an die mehrphasige Energieversorgungsleitung angeschlossen ist, und eine Fehlerdetektionseinrichtung, die mittelbar und unmittelbar an eine Sekundärseite des Messwandlers angeschlossen ist und diesen auf das Auftreten eines Fehlers bzw. Ausfalls, wie oben beschrieben überwacht. Bei der Fehlerdetektionseinrichtung handelt es sich vorzugsweise um eine Fehlerdetektionseinrichtung, wie sie oben beschrieben wurde. Die Fehlerdetektionseinrichtung arbeitet vorzugsweise so, dass sie das oben beschriebene Verfahren ausführt.

Bei dem Messwandler handelt es sich vorzugsweise um einen induktiven Strom- oder Spannungswandler, einen Kleinsignalwandler, eine Rogowskispule, einen ohmschen und/oder kapazitiven Teiler oder eine Verschiebungsstrommessung durch einen Primärkondensator.

Die Erfindung wird nachfolgend anhand von Ausführungsbeispielen näher erläutert, dabei zeigen beispielhaft

Figur 1 ein Ausführungsbeispiel für eine Anordnung, die mit einem Ausführungsbeispiel für eine erfindungsgemäße Fehlerdetektionseinrichtung ausgestattet ist, bei der Summenbildner und eine Vergleichseinrichtung hardwaremäßig separate Komponenten der Fehlerdetektionseinrichtung sind,

Figur 2 ein Ausführungsbeispiel für eine Anordnung, die mit einem Ausführungsbeispiel für eine erfindungsgemäße Fehlerdetektionseinrichtung ausgestattet ist, bei der Summenbildner und eine Vergleichseinrichtung der Fehlerdetektionseinrichtung durch Softwaremodule gebildet sind,

Figur 3 ein Ausführungsbeispiel für eine Anordnung, die mit einem Ausführungsbeispiel für eine erfindungsgemäße Fehlerdetektionseinrichtung ausgestattet ist, bei der Maximal- und Minimalwertbildner und eine Vergleichseinrichtung hardwaremäßig separate Komponenten der Fehlerdetektionseinrichtung sind, und

Figur 4 ein Ausführungsbeispiel für eine Anordnung, die mit einem Ausführungsbeispiel für eine erfindungsgemäße Fehlerdetektionseinrichtung ausgestattet ist, bei der Maximal- und Minimalwertbildner und eine Vergleichseinrichtung der Fehlerdetektionseinrichtung durch Softwaremodule gebildet sind.

In den Figuren werden der Übersicht halber für identische oder vergleichbare Komponenten stets dieselben Bezugszeichen verwendet.

Die Figur 1 zeigt eine dreiphasige elektrische Energieversorgungsleitung 10, deren erste, zweite und dritte Phase in der Figur 1 mit den Bezugszeichen L1, L2 und L3 gekennzeichnet sind. Ein Neutralleiter der dreiphasigen Energieversorgungsleitung 10 trägt das Bezugszeichen N.

An die dreiphasige Energieversorgungsleitung 10 ist mit seiner Primärseite ein dreiphasiger Messwandler 20 angeschlossen, dessen Sekundärseite 21 pro Phase mit jeweils einem zugeordneten A/D-Wandler 31, 32 bzw. 33 in Verbindung steht.

Die Funktion der drei A/D-Wandler 31, 32 und 33 besteht darin, die auf der Analogseite der drei A/D-Wandler bzw. auf der analogen Sekundärseite 21 des Messwandlers 20 vorhandenen Sekundärsignale in digitale Signale in Form eines ersten, zweiten und dritten Sekundärmesswerts M1, M2 und M3 umzuwandeln oder zumindest Abtastwerte bereitzustellen, die die Ermittlung der Sekundärmesswerte M1, M2 und M3 durch nicht weiter dargestellte Zwischenkomponenten ermöglichen.

Da es sich bei den auf der Sekundärseite 21 vorliegenden Sekundärsignalen um - von Oberwellen oder Störungen abgesehen - sinusförmige Wechselsignale mit der Grundfrequenz der Energieversorgungsleitung 10 handelt, wird beispielhaft davon ausgegangen, dass die nachfolgend beschriebene Auswertung auf die Signalamplitude oder den Effektivwert des jeweiligen Sekundärsignals - bezogen auf die Grundfrequenz der Energieversorgungsleitung 10 - abstellt und die Sekundärmesswerte M1, M2 und M3 demgemäß beispielsweise Amplituden- oder Effektivwerte sein können.

Die Bildung solcher Amplituden- oder Effektivwerte anhand von Abtastwerten ist allgemein bekannt und kann beispielsweise durch eine Fouriertransformation erfolgen, die in Zwischenkomponenten erfolgen kann, die in den Figuren aus Gründen der Übersicht nicht weiter dargestellt sind. Diese Zwischenkomponenten können in die A/D-Wandler 31, 32 und 33 integriert sein, zwischen den A/D-Wandlern 31, 32 und 33 und einer nachgeordneten Fehlerdetektionseinrichtung 40 angeordnet werden oder auch Teil der Fehlerdetektionseinrichtung 40 sein.

Bei den Sekundärsignalen kann es sich um auf der Sekundärseite 21 fließende Sekundärströme I1, I2 oder I3 oder alternativ auch um Sekundärspannungen U1, U2 und U3 handeln, die an den drei A/D-Wandlern bzw. auf der Sekundärseite 21 anliegen.

Den drei A/D-Wandlern 31, 32 und 33 ist die Fehlerdetektionseinrichtung 40 nachgeordnet, die die Sekundärmesswerte M1, M2 und M3 mit Blick auf das Erkennen eines Fehlers bzw. Ausfalls des Messwandlers 20 auswertet.

Bei dem Ausführungsbeispiel gemäß Figur 1 umfasst die Fehlerdetektionseinrichtung 40 einen ersten Summenbildner 41, einen zweiten Summenbildner 42 und einen dritten Summenbildner 43.

Den drei Summenbildnern 41 bis 43 ist eine Vergleichseinrichtung 44 nachgeordnet.

Aufgrund des physikalischen Aufbaus des Messwandlers 20, insbesondere aufgrund der räumlichen Nähe zwischen den Signalleitern 22 der drei Phasen auf der Sekundärseite 21 des Messwandlers 20, wird es zumindest im geringen Maße zu einem Überkoppeln der Sekundärsignale jeder der Phasen auf die jeweils beiden anderen Phasen kommen. Die durch das Überkoppeln in den Sekundärsignalen enthaltenen Überkoppelsignale verfälschen zwar die Sekundärsignale als solche, jedoch lassen sie sich in vorteilhafter Weise zum Erkennen eines Ausfalls des Messwandlers 20 heranziehen.

Koppelwerte, die das phasenpaarbezogene Überkoppeln zwischen den Phasen eines jeden der Phasenpaare quantifizieren, sind in der Figur 1 mit den Bezugszeichen K12, K21, K13, K31, K23, K32 gekennzeichnet.

Die Fehlerdetektionseinrichtung 40 gemäß Figur 1 kann beispielsweise wie folgt betrieben werden:
Der erste Summenbildner 41 bildet einen ersten Summenwert SUM1, indem er die Überkoppelsignale, die die zweite Phase L2 und die dritte Phase L3 in der ersten Phase L1 hervorrufen, unter Bildung phasenpaarbezogener Teilkoppelsignalwerte K12·M2 bzw. K13·M3 ermittelt und diese aufsummiert, beispielsweise gemäß

$$SUM1 = K12 \cdot M2 + K13 \cdot M3,$$

wobei K12 einen phasenpaarbezogenen Koppelfaktor bezeichnet, der das Überkoppeln des Sekundärsignals der zweiten Phase L2 auf das Sekundärsignal der ersten Phase L1 quantifiziert, und K13 einen phasenpaarbezogenen Koppelfaktor bezeichnet, der das Überkoppeln des Sekundärsignals der dritten Phase L3 auf das Sekundärsignal der ersten Phase L1 quantifiziert.

Der erste Summenwert SUM1 gibt somit zumindest näherungsweise an, wie groß das durch die zweite und dritte Phase L2 und L3 hervorgerufene Überkoppelsignal im Sekundärsignal der ersten Phase L1 ist.

Im fehlerfreien Fall bzw. bei ununterbrochenen Messleitungen 22 des Messwandlers 20 muss das Sekundärsignal der ersten Phase L1 auf der Sekundärseite 21 mindestens so groß wie dieses Überkoppelsignal sein; mit anderen Worten muss der erste Sekundärmesswert M1 also mindestens so groß sein wie der zugehörige erste Summenwert SUM1, der für die erste Phase L1 einen phasenbezogenen Mindestschwellenwert bildet.

Übersteigt der erste Sekundärmesswert M1 den zugehörigen ersten Summenwert SUM1, so ist der Sekundärmesswert M1 plausibel, sodass auf eine Ausfallfreiheit des Messwandlers 20 hinsichtlich der ersten Phase L1 geschlossen werden kann.

Unterschreitet hingegen der erste Sekundärmesswert M1 den zugehörigen ersten Summenwert SUM1, so ist dies unplausibel und es liegt ein Fehler vor.

In entsprechender Weise arbeiten der zweiten Summenbildner 42 und der dritte Summenbildner 43: Der zweite Summenbildner 42 bildet einen zweiten Summenwert SUM2, indem er die Überkoppelsignale, die die erste Phase L1 und die dritte Phase L3 in der zweiten Phase L2 hervorrufen, unter Bildung phasenpaarbezogener Teilkoppelsignalwerte ermittelt und diese aufsummiert, beispielsweise gemäß

$$SUM2 = K21 \cdot M1 + K23 \cdot M3,$$

wobei K21 einen phasenpaarbezogenen Koppelfaktor bezeichnet, der das Überkoppeln des Sekundärsignals der ersten Phase L1 auf das Sekundärsignal der zweiten Phase L2 quantifiziert, und K23 einen phasenpaarbezogenen Koppelfaktor bezeichnet, der das Überkoppeln des Sekundärsignals der dritten Phase L3 auf das Sekundärsignal der zweiten Phase L2 quantifiziert.

Der dritte Summenbildner 43 bildet einen dritten Summenwert SUM3, indem er die Überkoppelsignale, die die erste Phase L1 und die zweite Phase L2 in der dritten Phase L3 hervorrufen, unter Bildung phasenpaarbezogener Teilkoppelsignalwerte ermittelt und diese aufsummiert, beispielsweise gemäß

$$SUM2 = K31 \cdot M1 + K32 \cdot M2,$$

wobei K31 einen phasenpaarbezogenen Koppelfaktor bezeichnet, der das Überkoppeln des Sekundärsignals der ersten Phase L1 auf das Sekundärsignal der dritten Phase L3 quantifiziert, und K32 einen phasenpaarbezogenen Koppelfaktor bezeichnet, der das Überkoppeln des Sekundärsignals der zweiten Phase L2 auf das Sekundärsignal der dritten Phase L3 quantifiziert.

Aufgrund von Symmetriegründen sind in der Regel die Koppelfaktoren K13 und K31, die Koppelfaktoren K23 und K32 und die Koppelfaktoren K12 und K21 jeweils paarweise gleich groß.

Die Vergleichseinrichtung 44 führt die bereits angesprochenen Vergleichsoperationen durch und vergleicht den ersten Sekundärmesswert M1 mit dem ersten Summenwert SUM1, den zweiten Sekundärmesswert M2 mit dem zweiten Summenwert SUM2 und den dritten Sekundärmesswert M3 mit dem dritten Summenwert SUM3 und schließt, wie bereits beschrieben, in Abhängigkeit von dem jeweiligen Vergleichsergebnis auf Ausfallfreiheit oder auf das Auftreten eines Fehlers hinsichtlich der jeweils betrachteten Phase L1, L2 und L3 des Messwandlers 20.

Beispielsweise erzeugt die Vergleichseinrichtung 44 ein Blockadesignal BS, das einen Fehler anzeigt und mit dem Schutzgerätefunktionen eines Schutzgerätes blockiert werden können, wenn gilt:
(M1<SUM1 oder M2<SUM2 oder M3<SUM3) => Ausgabe von BS

Die beschriebenen Summenbildner 41 bis 43 und die Vergleichseinrichtung 44 können hardwaremäßig separat realisierte Bauelemente sein; alternativ ist es möglich, die drei Summenbildner 41 bis 43 und die Vergleichseinrichtung 44 als Softwaremodule auszuführen, wie nachfolgend im Zusammenhang mit der Figur 2 beschrieben wird.

Die Figur 2 zeigt eine Rechenanlage 400, die ein Schutzgerät oder eine Merging Unit bilden kann oder ein Bestandteil eines Schutzgerätes oder einer Merging Unit sein kann. Die Rechenanlage 400 umfasst eine Recheneinrichtung 410 und einen Speicher 420. In dem Speicher 420 sind drei Softwaremodule M41 bis M43 abgespeichert, die bei Ausführung durch die Recheneinrichtung 410 die oben im Zusammenhang mit der Figur 1 beschriebenen Summenbildner 41 bis 43 bilden.

Ein Softwaremodul M44 bildet bei Ausführung durch die Recheneinrichtung 410 eine Vergleichseinrichtung 44, wie sie ebenfalls im Zusammenhang mit der Figur 1 beschrieben worden ist.

Die Softwaremodule M41-M44 sind Bestandteile eines Fehlerdetektionssoftwaremoduls M40, das bei Ausführung durch die Recheneinrichtung 410 die Fehlerdetektionseinrichtung 40 gemäß Figur 1 bildet.

Im Übrigen gelten die obigen Ausführungen im Zusammenhang mit der Figur 1 beim Ausführungsbeispiel gemäß Figur 2 entsprechend.

Die Figur 3 zeigt ein weiteres Ausführungsbeispiel für eine Fehlerdetektionseinrichtung 40. Bei dieser Fehlerdetektionseinrichtung 40 sind eingangsseitig eine Maximalwertermittlungseinrichtung 45 und eine Minimalwertermittlungseinrichtung 46 vorgesehen sind.

Die Maximalwertermittlungseinrichtung 45 ermittelt von den drei eingangsseitig anliegenden Sekundärmesswerten M1 bis M3 denjenigen, der den größten Betrag bzw. die größte Signalamplitude beschreibt und gibt diesen als Maximalwert Mmax aus.

Die Minimalwertbestimmungseinrichtung 46 ermittelt in analoger Weise denjenigen Sekundärmesswert bzw. diejenige Phase, das bzw. die den kleinsten Betrag bzw. die kleinste Amplitude aufweist, und gibt dessen Größe als Minimalwert Mmin aus.

Der Maximalwert Mmax und der Minimalwert Mmin gelangen zu einer Vergleichseinrichtung 47, die prüft, ob der Minimalwert Mmin größer als ein phasenpaarbezogener Mindestschwellenwert ist.

Der phasenpaarbezogene Mindestschwellenwert wird bei dem Ausführungsbeispiel gemäß Figur 3 durch Multiplikation des Maximalwerts Mmax mit einem phasenpaarbezogenen Koppelwert Kmaxmin gebildet, der das Überkoppeln zwischen der Phase mit dem größten Sekundärmesswert und der Phase mit dem kleinsten Sekundärmesswert quantitativ beschreibt.

Überschreitet der Minimalwert Mmin den Mindestschwellenwert, so wird auf Ausfallfreiheit geschlossen, anderenfalls auf das Vorliegen eines Fehlers und es wird vorzugsweise ein Blockadesignal BS erzeugt.

Die Figur 4 zeigt eine Ausführungsvariante des Ausführungsbeispiels gemäß Figur 3. Bei der Ausführungsvariante gemäß Figur 4 sind die Maximalwertermittlungseinrichtung 45 und die Minimalwertermittlungseinrichtung 46 sowie die nachgeordnete Vergleichseinrichtung 47 als Softwaremodule M45, M46 bzw. M47 ausgestaltet, die in einem Speicher 420 einer Rechenanlage 400 abgespeichert sind und bei Ausführung durch eine Recheneinrichtung 410 der Rechenanlage 400 die beschriebenen Rechen- bzw. Vergleichsoperationen durchführen.

Die Rechenanlagen 400 gemäß Figur 2 und 4 können ein Schutzgerät oder eine Merging Unit bilden oder ein Bestandteil eines Schutzgerätes oder einer Merging Unit sein. Auch können die Fehlerdetektionseinrichtungen 40 gemäß den Figuren 1 und 3 in Schutzgeräte oder Merging Units integriert werden.

Abschließend sei erwähnt, dass die Merkmale aller oben beschriebenen Ausführungsbeispiele untereinander in beliebiger Weise kombiniert werden können, um weitere andere Ausführungsbeispiele der Erfindung zu bilden.

Auch können alle Merkmale von Unteransprüchen jeweils für sich mit jedem der nebengeordneten Ansprüche kombiniert werden, und zwar jeweils für sich allein oder in beliebiger Kombination mit einem oder mehreren anderen Unteransprüchen, um weitere andere Ausführungsbeispiele zu erhalten.

## Patentansprüche

**1.** Verfahren zum Erkennen eines Fehlers eines mehrphasigen analogen Messwandlers (20),
**dadurch gekennzeichnet, dass**

- für jede Phase (L1, L2, L3) des Messwandlers (20) jeweils ein Sekundärmesswert (M1, M2, M3) gebildet wird, der ein auf einer Sekundärseite (21) des Messwandlers (20) vorliegendes Sekundärsignal beschreibt,
- für eine zu überprüfende Phase (L1, L2, L3) des Messwandlers (20) ein Mindestschwellenwert ermittelt wird, der ein Überkoppelsignal angibt, das im fehlerfreien Falle durch ein Übersprechen einer oder mehrerer anderer Phasen (L1, L2, L3) des Messwandlers (20) auf der Sekundärseite (21) der zu überprüfenden Phase (L1, L2, L3) mindestens vorliegen müsste,
- der Sekundärmesswert (M1, M2, M3) der zu überprüfenden Phase (L1, L2, L3) mit dem Mindestschwellenwert verglichen wird und
- in Abhängigkeit von dem Vergleichsergebnis auf Ausfallfreiheit oder das Auftreten eines Fehlers bezüglich der zu überprüfenden Phase (L1, L2, L3) des Messwandlers (20) geschlossen wird.

**2.** Verfahren nach Anspruch 1,
**dadurch gekennzeichnet, dass** auf Ausfallfreiheit in der zu überprüfenden Phase (L1, L2, L3) des Messwandlers (20) geschlossen wird, wenn der Sekundärmesswert (M1, M2, M3) den Mindestschwellenwert überschreitet.

**3.** Verfahren nach einem der voranstehenden Ansprüche,
**dadurch gekennzeichnet, dass** auf einen Fehler in der zu überprüfenden Phase (L1, L2, L3) des Messwandlers (20) geschlossen wird, wenn der Sekundärmesswert (M1, M2, M3) den Mindestschwellenwert unterschreitet.

**4.** Verfahren nach einem der voranstehenden Ansprüche,
**dadurch gekennzeichnet, dass**

- für jede der anderen Phasen (L1, L2, L3) als der zu überprüfenden Phase (L1, L2, L3) jeweils ein phasenpaarbezogener Teilkoppelsignalwert errechnet wird, und zwar durch Multiplikation eines phasenpaarbezogenen, das Überkoppeln zwischen der jeweiligen anderen Phase (L1, L2, L3) und der zu überprüfenden Phase (L1, L2, L3) quantifizierenden Koppelwerts (K12, K21, K13, K31, K23, K32) und dem Sekundärmesswert (M1, M2, M3) der jeweiligen anderen Phase (L1, L2, L3),
- die phasenpaarbezogenen Teilkoppelsignalwerte der anderen Phasen (L1, L2, L3) unter Bildung eines Summenwerts (SUM1, SUM2, SUM3) aufsummiert werden und
- der Summenwert (SUM1, SUM2, SUM3) als der Mindestschwellenwert angesehen und für den Vergleich mit dem Sekundärmesswert (M1, M2, M3) der zu überprüfenden Phase (L1, L2, L3) herangezogen wird.

**5.** Verfahren nach einem der voranstehenden Ansprüche 1 bis 3,
**dadurch gekennzeichnet, dass**

- für eine andere als die zu überprüfende Phase (L1, L2, L3) ein phasenpaarbezogener Teilkoppelsignalwert errechnet wird, und zwar durch Multiplikation eines phasenpaarbezogenen, das Überkoppeln zwischen der anderen Phase (L1, L2, L3) und der zu überprüfenden Phase (L1, L2, L3) quantifizierenden Koppelwerts (K12, K21, K13, K31, K23, K32) und dem Sekundärmesswert (M1, M2, M3) der anderen Phase (L1, L2, L3), und

- der phasenpaarbezogene Teilkoppelsignalwert als der Mindestschwellenwert angesehen und für den Vergleich mit dem Sekundärmesswert (M1, M2, M3) der zu überprüfenden Phase (L1, L2, L3) herangezogen wird.

**6.** Verfahren nach Anspruch 5,
**dadurch gekennzeichnet, dass**

- als die andere als die zu überprüfende Phase (L1, L2, L3) diejenige andere Phase (L1, L2, L3) ausgewählt wird, deren Sekundärmesswert (M1, M2, M3) der größte Sekundärmesswert ((M1, M2, M3) im Vergleich zu den Sekundärmesswerten (M1, M2, M3) aller übrigen der anderen Phasen (L1, L2, L3) ist, und
- als die zu überprüfende Phase (L1, L2, L3) diejenige Phase (L1, L2, L3) ausgewählt wird, deren Sekundärmesswert (M1, M2, M3) der kleinste ist.

**7.** Verfahren nach einem der voranstehenden Ansprüche 5 bis 6,
**dadurch gekennzeichnet, dass** auf einen Fehler in der zu überprüfenden Phase (L1, L2, L3) des Messwandlers (20) geschlossen wird, wenn der Sekundärmesswert (M1, M2, M3) den phasenpaarbezogenen Teilkoppelsignalwert unterschreitet.

**8.** Verfahren nach einem der voranstehenden Ansprüche,
**dadurch gekennzeichnet, dass** jede der Phasen (L1, L2, L3) des Messwandlers (20) jeweils auf das Vorliegen eines Fehlers geprüft wird, indem das Verfahren für jede der Phasen (L1, L2, L3) als zu überprüfende Phase (L1, L2, L3) durchgeführt wird.

**9.** Verfahren nach einem der voranstehenden Ansprüche,
**dadurch gekennzeichnet, dass**

- die Sekundärsignale Sekundärströme (I1, 12, I3) und die Sekundärmesswerte (M1, M2, M3) Sekundärstromwerte sind, die die auf der Sekundärseite (21) fließenden Sekundärströme (I1, I2, I3) angeben, und die Überkoppelsignale Überkoppelströme sind oder
- die Sekundärsignale Sekundärspannungen (U1, U2, U3) und die Sekundärmesswerte (M1, M2, M3) Sekundärspannungswerte sind, die die auf der Sekundärseite (21) anliegenden Sekundärspannungen (U1, U2, U3) angeben, und die Überkoppelsignale Überkoppelspannungen sind.

**10.** Verfahren nach einem der voranstehenden Ansprüche,
**dadurch gekennzeichnet, dass** im Falle, dass auf das Auftreten eines Fehlers des Messwandlers (20) geschlossen wird, ein Blockadesignal (BS) erzeugt wird, mit dem zumindest eine Schutzfunktion eines Schutzgeräts blockiert wird.

**11.** Fehlerdetektionseinrichtung (40) zum Erkennen eines Fehlers in einer Phase (L1, L2, L3) eines mehrphasigen analogen Messwandlers (20),
**dadurch gekennzeichnet, dass** die Fehlerdetektionseinrichtung (40) eine Vergleichseinrichtung (44, M44, 47, M47) aufweist, die

- für eine zu überprüfende Phase (L1, L2, L3) des Messwandlers (20) einen Mindestschwellenwert ermittelt, der ein Überkoppelsignal beschreibt, das im fehlerfreien Falle durch ein Übersprechen einer oder mehrerer anderer Phasen (L1, L2, L3) des Messwandlers (20) auf der Sekundärseite (21) der zu prüfenden Phase (L1, L2, L3) mindestens vorliegen müsste,
- einen das auf der Sekundärseite (21) der zu prüfenden Phase (L1, L2, L3) tatsächlich vorliegende Sekundärsignal angebenden Sekundärmesswert (M1, M2, M3) mit dem Mindestschwellenwert vergleicht und
- in Abhängigkeit von dem Vergleichsergebnis auf Ausfallfreiheit oder das Auftreten eines Fehlers in der zu überprüfenden Phase (L1, L2, L3) des Messwandlers (20) schließt.

**12.** Fehlerdetektionseinrichtung (40) nach Anspruch 11,
**dadurch gekennzeichnet, dass** die Fehlerdetektionseinrichtung (40) dazu ausgestaltet ist, den Messwandler (20) für jede der Phasen (L1, L2, L3) individuell auf das Vorliegen eines Fehlers hin zu prüfen.

**13.** Fehlerdetektionseinrichtung (40) nach Anspruch 11 oder 12,
**dadurch gekennzeichnet, dass** die Fehlerdetektionseinrichtung (40) als Funktionsmodul in ein Schutzgerät oder eine Merging Unit integriert ist.

**14.** Fehlerdetektionseinrichtung (40) nach einem der voranstehenden Ansprüche 11 bis 13,
**dadurch gekennzeichnet, dass** die Fehlerdetektionseinrichtung (40) durch ein Softwaremodul gebildet ist, das auf einer Rechenanlage (400) installiert ist.

**15.** Fehlerdetektionseinrichtung (40) nach einem der voranstehenden Ansprüche 12 bis 14,
**dadurch gekennzeichnet, dass** die Fehlerdetektionseinrichtung (40) durch ein Softwaremodul (M40) gebildet ist, das einen Bestandteil der Betriebssoftware eines Schutzgeräts oder einer Merging Unit bildet.

FIG 1

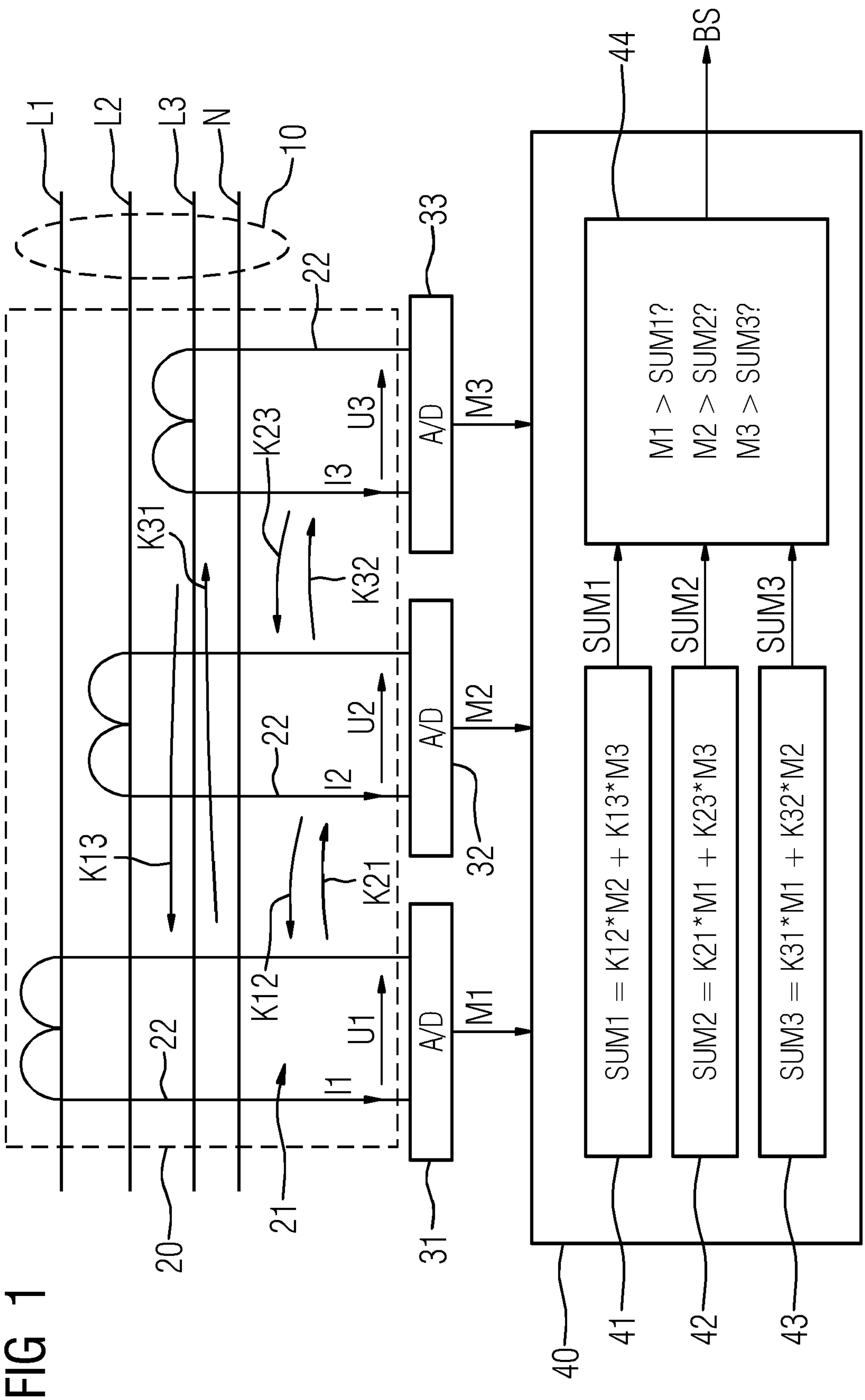
L1
L2
L3
N
10
20
21
22
K12
K13
K21
K31
K23
K32
I1
I2
I3
U1
U2
U3
A/D
M1
M2
M3
31
32
33
40
41
42
43
44
SUM1 = K12*M2 + K13*M3
SUM2 = K21*M1 + K23*M3
SUM3 = K31*M1 + K32*M2
SUM1
SUM2
SUM3
M1 > SUM1?
M2 > SUM2?
M3 > SUM3?
BS

FIG 2

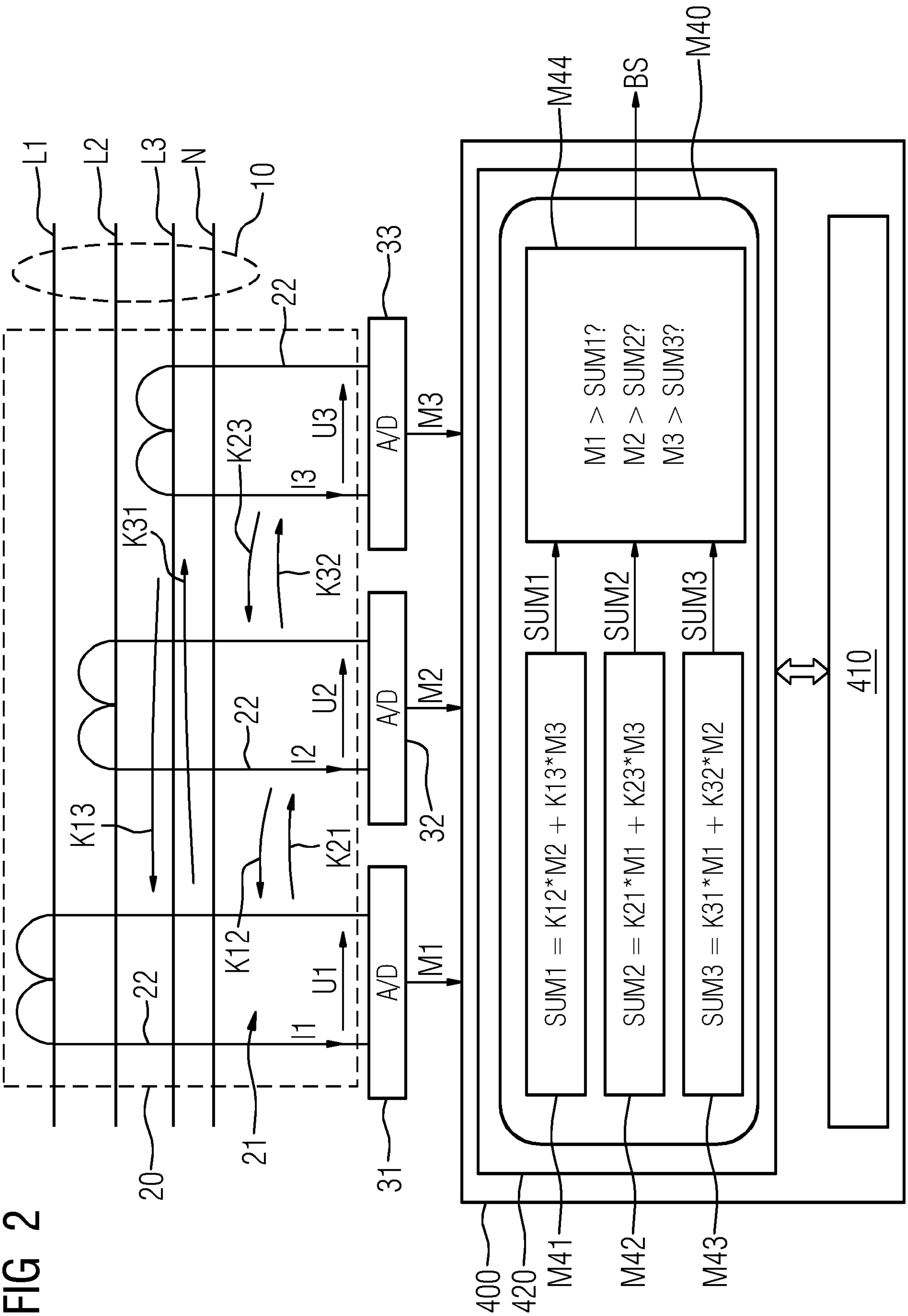
L1
L2
L3
N
10
20
21
22
K12
K13
K21
K23
K31
K32
I1
I2
I3
U1
U2
U3
A/D
M1
M2
M3
31
32
33
SUM1 = K12*M2 + K13*M3
SUM2 = K21*M1 + K23*M3
SUM3 = K31*M1 + K32*M2
SUM1
SUM2
SUM3
M1 > SUM1?
M2 > SUM2?
M3 > SUM3?
BS
M40
M41
M42
M43
M44
400
410
420

FIG 3

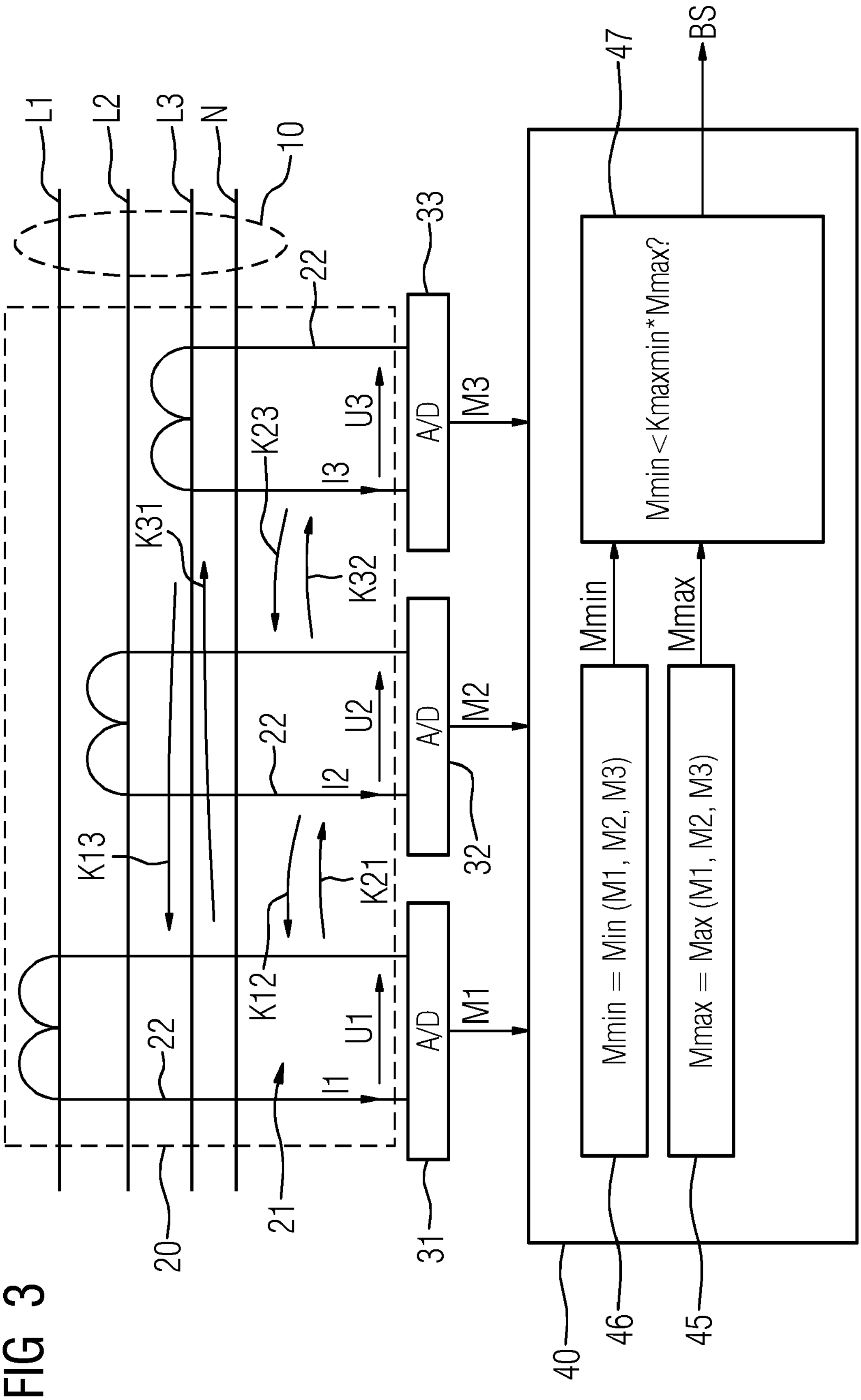
L1
L2
L3
N
10
20
21
22
K12
K13
K21
K23
K31
K32
I1
I2
I3
U1
U2
U3
A/D
M1
M2
M3
31
32
33
40
45
46
47
Mmin = Min (M1, M2, M3)
Mmax = Max (M1, M2, M3)
Mmin
Mmax
Mmin <Kmaxmin*Mmax?
BS

FIG 4

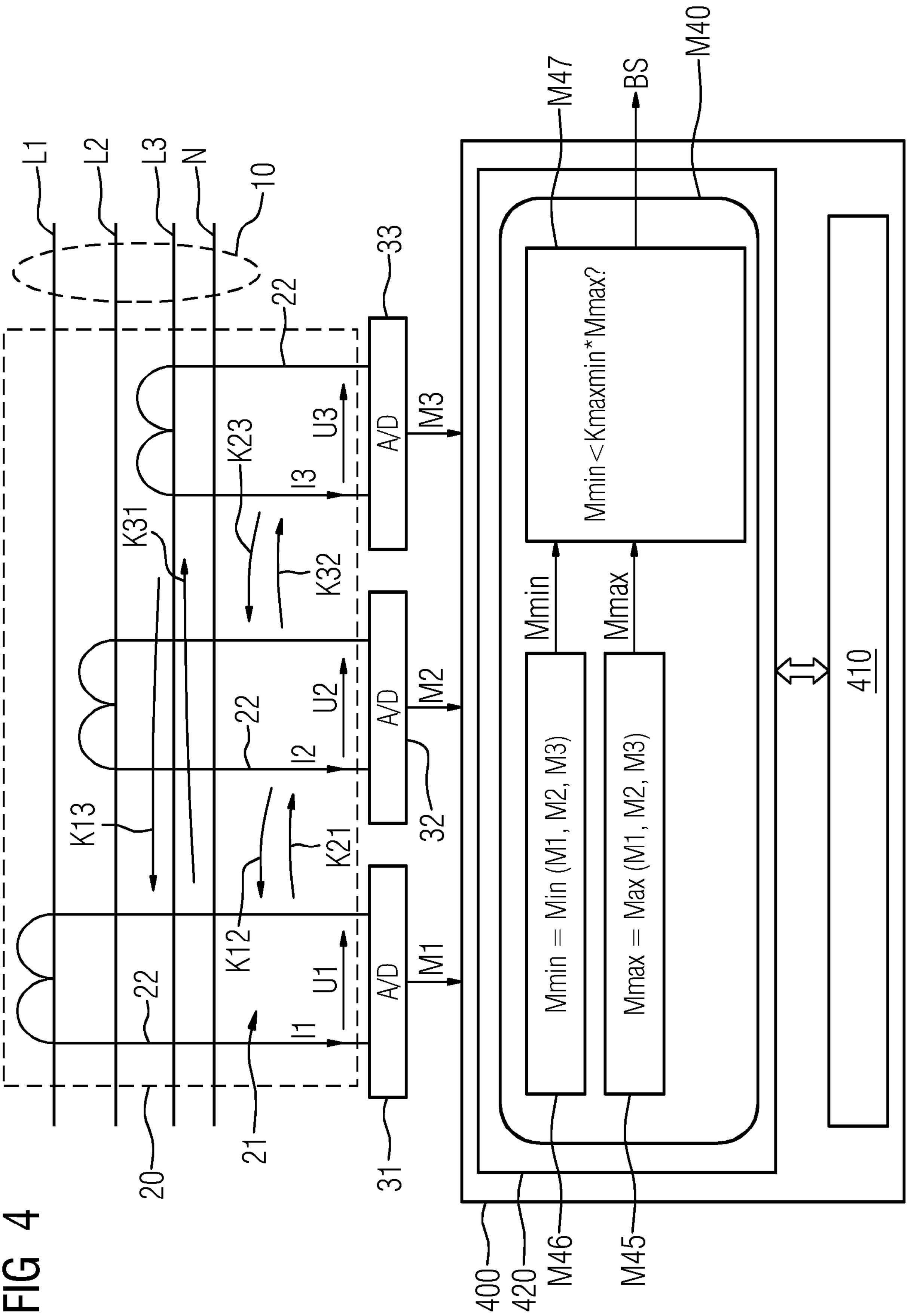
L1
L2
L3
N
10
20
21
22
31
32
33
A/D
M1
M2
M3
U1
U2
U3
I1
I2
I3
K12
K13
K21
K23
K31
K32
Mmin = Min (M1, M2, M3)
Mmax = Max (M1, M2, M3)
Mmin < Kmaxmin*Mmax?
Mmin
Mmax
BS
M40
M45
M46
M47
400
410
420

Europäisches Patentamt
European Patent Office
Office européen des brevets

# EUROPÄISCHER RECHERCHENBERICHT

Nummer der Anmeldung
EP 22 21 1010

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X<br>A | WO 2012/155974 A1 (SIEMENS AG [DE]; BEJMERT DANIEL [PL] ET AL.) 22. November 2012 (2012-11-22)<br>* Seite 1, Zeile 5 - Zeile 21; Anspruch 1; Abbildung 1 *<br>* Seite 9, Zeile 10 - Seite 10, Zeile 4 *<br>----- | 1-3,8-15<br>4-7 | INV.<br>G01R31/62 |
| A | US 2007/052426 A1 (WELLS CHARLES H [US] ET AL) 8. März 2007 (2007-03-08)<br>* Absatz [0015] - Absatz [0025]; Abbildung 2 *<br>----- | 1-15 | |
| A | DE 969 345 C (KOCH & STERZEL AG) 22. Mai 1958 (1958-05-22)<br>* Anspruch 1 *<br>----- | 1-15 | |
| A | EP 0 591 942 A1 (METRAWATT GMBH GOSSEN [DE]) 13. April 1994 (1994-04-13)<br>* Anspruch 1 *<br>----- | 1-15 | |
| A | US 7 119 548 B1 (COOK JOHN S [US] ET AL) 10. Oktober 2006 (2006-10-10)<br>* Anspruch 1; Abbildung 2 *<br>----- | 1-15 | RECHERCHIERTE SACHGEBIETE (IPC)<br>G01R |

Der vorliegende Recherchenbericht wurde für alle Patentansprüche erstellt

2

| Recherchenort | Abschlußdatum der Recherche | Prüfer |
|---|---|---|
| München | 7. Juni 2023 | Meliani, Chafik |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.......................................................................
& : Mitglied der gleichen Patentfamilie, übereinstimmendes Dokument

EPO FORM 1503 03.82 (P04C03)

## ANHANG ZUM EUROPÄISCHEN RECHERCHENBERICHT ÜBER DIE EUROPÄISCHE PATENTANMELDUNG NR.

EP 22 21 1010

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

07-06-2023

| Im Recherchenbericht angeführtes Patentdokument | Datum der Veröffentlichung | Mitglied(er) der Patentfamilie | Datum der Veröffentlichung |
|---|---|---|---|
| WO 2012155974 A1 | 22-11-2012 | BR 112013029461 A2 | 17-01-2017 |
| | | CN 103493321 A | 01-01-2014 |
| | | EP 2697880 A1 | 19-02-2014 |
| | | RU 2013156412 A | 27-06-2015 |
| | | US 2014095087 A1 | 03-04-2014 |
| | | WO 2012155974 A1 | 22-11-2012 |
| US 2007052426 A1 | 08-03-2007 | KEINE | |
| DE 969345 C | 22-05-1958 | KEINE | |
| EP 0591942 A1 | 13-04-1994 | DE 9213457 U1 | 28-01-1993 |
| | | EP 0591942 A1 | 13-04-1994 |
| US 7119548 B1 | 10-10-2006 | US 7119548 B1 | 10-10-2006 |
| | | US 2007108995 A1 | 17-05-2007 |

EPO FORM P0461

Für nähere Einzelheiten zu diesem Anhang : siehe Amtsblatt des Europäischen Patentamts, Nr.12/82